# EUROPEAN PATENT APPLICATION

(11) **EP 3 399 648 A1**
(43) Date of publication of application: **07.11.2018**
(21) Application number: 18166041.6
(22) Date of filing: 06.04.2018
(51) Int. Cl.: H03K 17/955

(54) **PROXIMITY SENSOR**

(30) Priority: 01.05.2017 JP 2017091240
(71) Applicant: Hosiden Corporation, Yao-shi, Osaka 581-0071 (JP)
(72) Inventor: Tsuduki, Shiro, Yao-shi, Osaka 5810071 (JP); Toyota, Naoki, Yao-shi, Osaka 5810071 (JP)
(74) Representative: Lemcke, Brommer & Partner Patentanwälte Partnerschaft mbB

(57) **Abstract**

A proximity sensor (100) configured to detect proximity of an object based on an electrostatic capacitance includes an electrode section (10) comprised of a tubular body formed by using a metal material and having a connecting terminal (11) on one side in an axial direction of the tubular body, a substrate (20) having a land (21) formed in correspondence in position to the connecting terminal (11), the connecting terminal (11) being fusedly solder-bonded to the land (21), with the tubular body being disposed vertically, and a detecting section (30) mounted on the substrate (20) and configured to detect the proximity of the object according to a change that occurs in an electrostatic capacitance at the electrode section (10).

## Description

### TECHNICAL FIELD

This disclosure relates to a proximity sensor configured to detect proximity of an object based on electrostatic capacitance.

### RELATED ART

Conventionally, a proximity sensor for detecting proximity of an object has been in use. One example of such proximity sensor is known from e.g. JP2010-212145A.

The proximity sensor disclosed in JP2010-212145A detects proximity of an object based on an electrostatic capacitance of an electrode. This proximity sensor is constituted of an electrode section and a detecting section. The electrode section includes a ground electrode provided in the form of a sheet using a sheet-like substrate made of resin to be flexibly deformable and a metal foil formed thereon and an electrode paired with the ground electrode. The detecting section determines proximity of an object based on an electrostatic capacitance of the electrode section.

### SUMMARY

In the technique disclosed in JP2010-212145A, the electrode section is provided as a sheet-like substrate and this substrate is wrapped around an outer circumferential face of a support and fixed thereto. Therefore, at the time of manufacture of the proximity sensor, there arises a need for a work for the wrapping. Thus, there remains room for improvement in the respect of ease of assembly.

Embodiments of the present invention comprise a proximity sensor that allows easy assembly.

A proximity sensor according to this disclosure is a proximity sensor configured to detect proximity of an object based on an electrostatic capacitance, the proximity sensor comprising:
an electrode section comprised of a tubular body formed by using a metal material and having a connecting terminal on one side in an axial direction of the tubular body;
a substrate having a land formed in correspondence in position to the connecting terminal, the connecting terminal being fusedly solder-bonded to the land, with the tubular body being disposed vertically; and
a detecting section mounted on the substrate and configured to detect the proximity of the object according to a change that occurs in an electrostatic capacitance at the electrode section.

In the case of the above arrangement, when the detecting section is to be mounted on the substrate, the electrode section formed in advance of the tubular body too can be mounted thereon at the same time. So, the assembly of the proximity sensor can be made easier. Further, by changing the inside diameter or the height of the electrode section, compactization or thinning of the proximity sensor too will be made possible.

Further, according to one embodiment of the proximity sensor, the electrode section can be formed cylindrical.

In this case, the detection sensitivity of the electrode section can be made omnidirectional. Thus, proximity of an object can be detected over the entire circumference.

Further, according to one embodiment of the proximity sensor, the detecting section can be mounted to one of faces of the substrate which one face is directed toward the other end in the axial direction of the tubular body.

In this case, by disposing the detecting section radially inwardly of the electrode section, the detecting section can be accommodated inside the tubular body. Therefore, the detecting portion can be protected and moreover the proximity sensor can be formed compact.

Further, according to one embodiment of the proximity sensor, the connecting terminal can be arranged to protrude on the radial inner side of the tubular body on the one side in the axial direction.

In this case, the electrode section can be formed compact. Further, the size of the substrate too can be formed small.

### BRIEF DESCRIPTON OF THE DRAWINGS

Fig. 1 is a diagram schematically showing a proximity sensor,
Fig. 2 is an exploded view of the proximity sensor, and
Fig. 3 shows an application example of the proximity sensor.

### DESCRIPTON OF EMBODIMENTS

A contactless power supply apparatus relating to this disclosure is configured to detect proximity of an object based on an electrostatic capacitance and also to facilitate assembly. Next, a proximity sensor 100 according to this embodiment will be explained.

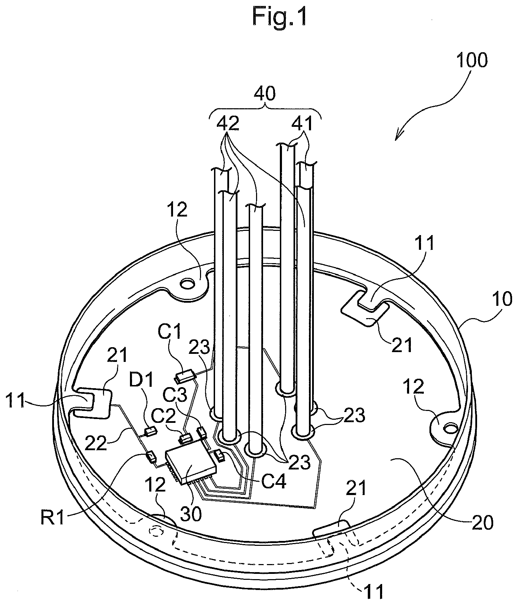

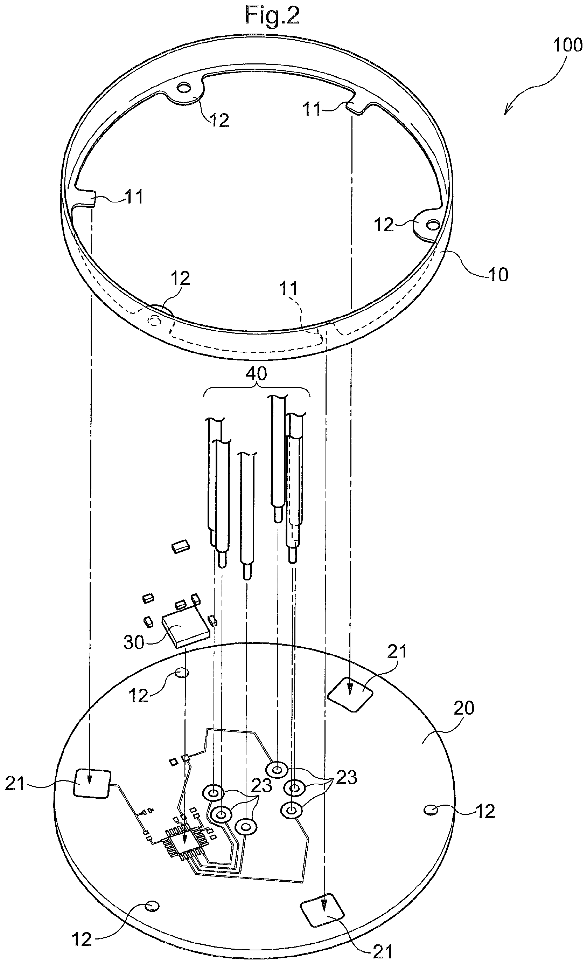

Fig. 1 is a diagram schematically showing a configuration of the proximity sensor 100 of this embodiment. Fig. 2 is an exploded view of the proximity sensor 100. As shown in Fig. 1 and Fig. 2, the proximity sensor 100 includes an electrode section 10, a substrate 20, a detecting section 30 and a harness 40.

The electrode section 10 is formed as a tubular body formed with using a metal material. The electrode section 10 is formed with using such metal material for facilitating polarization according to an electric charge of the object as the detection target of the proximity sensor 100. Further, the electrode section 10 is formed as such a tubular body using the metal material in order to allow detection of proximity of an object over a wide range (e.g. 360 degrees). In particular, in this embodiment, the electrode section 10 is formed cylindrical. With this, the outer circumferential face of the tubular body is used as a detecting face of the proximity sensor 100.

Further, the electrode section 10 includes a connecting terminal 11 at an end portion on one side in the axial direction of the tubular body. Here, the language "an end portion on one side in the axial direction of the tubular body" refers to one end portion of opposed end portions formed in the axial direction in the tubular body. Therefore, in the electrode section 10, the connecting terminal 11 is provided only on one side in the axial direction. The connecting terminal 11 is formed integral with the electrode section 10. Therefore, the connecting terminal 11 too is formed of using the metal material.

In the instant embodiment, the connecting terminal 11 is arranged to protrude on the radial inner side of the tubular body at the end on one side in the axial direction of the tubular body. Therefore, this connecting terminal 11 is formed as a convex body convex toward the radial inner side from the axial end face of the tubular body. A plurality of such connecting terminals 11 can be provided. In the instant embodiment, the electrode section 10 includes three such connecting terminals 11. Incidentally, it is advantageous if such connecting terminals 11 are disposed uniformly along the circumferential direction of the tubular body. As will be described later, since the connecting terminals 11 are solder-bonded to lands 21 of the substrate 20, the arrangement of disposing the connecting terminals 11 uniformly allows elimination of a portion which suffers weak fixation to the substrate 20. As a result, even if a stress should be applied to the electrode section 10 from the outside, inadvertent detachment of the electrode section 10 from the substrate 20 can be effectively resisted.

The substrate 20 includes the lands 21 which respectively have a shape (a round shape in this embodiment) whose outside diameter is same as the outside diameter of the tubular body and which are formed in correspondence to the positions of the connecting terminals 11. The substrate 20 can be constituted by using a known printed circuit board, for instance. The above language "formed in correspondence to the positions of the connecting terminals 11" means that the lands 21 are formed in such a manner that these lands 21 are in agreement with the respective connecting terminals 11 when the electrode section 10 is placed on the substrate 20.

In the substrate 20, the connecting terminals 11 are fusedly solder-bonded to the respective lands 21 with the tubular body being placed vertically. The above language "with the tubular body being placed vertically" means a state in which the electrode section 10 is placed on the substrate 20 with the one side end face in the axial direction of the tubular body being placed in opposition to the substrate 20. In particular, in this embodiment, of the opposed side end faces in the axial direction of the tubular body, the one end face in the axial direction provided with the above-described connecting terminals 11 is placed in opposition to the substrate 20. Under this state, the connecting terminals 11 are soldered to the lands 21. Incidentally, for position-fixing of the electrode section 10 relative to the substrate 20, positioning portions 12 are provided in the electrode section 10 and in the substrate 20, respectively so that with agreement between the positioning portions 12 in the electrode section 10 and the positioning portions 12 in the substrate 20, the soldering work can be carried out with high positional accuracy.

The detecting section 30 is mounted on the substrate 20 and detects proximity of an object according to a change occurring in the electrostatic capacitance in the electrode section 10. To this detecting section 30, at least one of the plurality of lands 21 is connected via a resistor R1. In this embodiment, in the detecting section 30, as shown in Fig. 1 and Fig. 2, one of the three lands 21 is connected via the resistor R1. Thus, the detecting section 30 and the electrode section 10 are electrically connected to each other. Here, the resistor R1 is a so-called damping resistor for reducing noise or electrostatic discharge (ESD). Therefore, this resistor R1 can be omitted in case noise or electrostatic discharge need not be taken into consideration.

The detection principle of such electrostatic capacitance type proximity sensor is known, so detailed explanation thereof will be omitted herein. Briefly, when an object approaches the electrode section 10, according to an electric charge born by the object, a corresponding polarization charge is developed in the electrode section 10. As the electrode section 10 is electrically connected to the detecting section 30 via the resistor R1 as described above. Of a pair of positive and negative charges, the charge having the sign different from that of the polarized charge will be gathered on the detecting section 30 side. Then, the detecting section 30 calculates an electrostatic capacitance according to this charge, thus detecting the proximity of the object.

The harness 40 is comprised of power harnesses 41 for supplying power to the detecting section 30 and signal harnesses 42 for providing control signals to the detecting section 30. The power harnesses 41 are comprised of a pair of positive and negative harnesses. The control signals provided by the signal harnesses 42 are such signals which are needed when the detecting section 30 effects object detection. Specifically, they are a clock signal or a detection signal indicative of a detection result, etc. These harnesses 40 are inserted into through holes 23 provided in the substrate 20.

On the substrate 20, bypass capacitors C1, C2, C3 are mounted in correspondence with the power harnesses 41 and the signal harnesses 42. Further, a detecting capacitor C4 too is mounted for the detecting section 30 to effect the calculation of the electrostatic capacitance in response to proximity of an object. Further, between a signal line 22 between the resistor R1 and the land 21 to which this resistor R1 is connected and the GND potential, an ESD suppressor D1 for ESD protection is provided. Incidentally, of terminals provided in the bypass capacitors C1, C2, C3, the detecting capacitor C4 and the ESD suppressor D1 respectively, the land to which the terminal connected to the GND potential is soldered is electrically connected via the through hole 23 in which the GND harness of the power harnesses 41 is inserted and the surface of the substrate 20.

Here, in this embodiment, the detecting section 30, the bypass capacitors C1, C2, C3, the detecting capacitor C4 and the ESD suppressor D1 are mounted on one of the faces of the substrate 20 which one face faces the axial other side of the tubular body. In this embodiment, the connecting terminals 11 are provided on the end portion on one side in the axial direction of the tubular body. Therefore, the above language "axial other side" means the axial end side of the tubular body where the connecting terminals 11 are not provided. Since the above-described components are mounted on such one face of the substrate 20 facing the axial other side, as shown in Fig. 1, these components are mounted between the axial one side end and the axial other side as seen in the radial direction of the electrode section 10. Namely, the components are enclosed by the electrode section 10. Therefore, the components can be protected by the electrode section 10. Further, compactization is made possible also. Moreover, as the arrangement requires only soldering of the electrode section 10 to the substrate 20, assembly of the proximity sensor 100 can be carried out easily.

Incidentally, the opposite face of the substrate 20 to its face on which the above-described components are mounted can have its entire face excluding the portion forming the land for the harness 40 formed as a ground layer. This ground layer is electrically connected to the through hole 23 in which the GND harness of the power harnesses 41 is inserted. In the case of such arrangement as above, the proximity sensor 100 can detect proximity of an object by its electrode section 10 only, but cannot detect object proximity by its substrate 20.

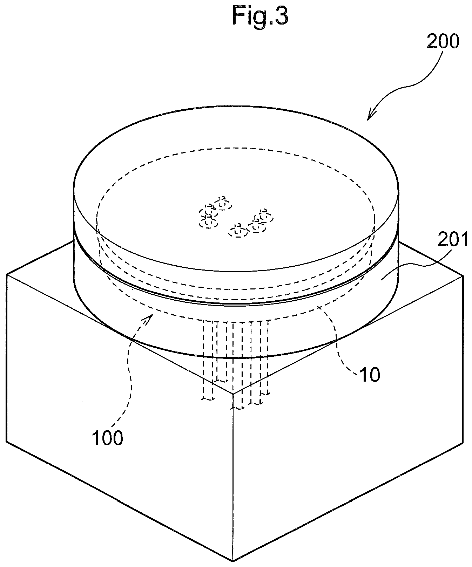

The above-described proximity sensor 100 can be used e.g. in a rotary switch 200 such as one shown in Fig. 3 for instance. This will be configured such that the outer circumferential face of the electrode section 10 of the proximity sensor 100 is covered by a tubular resin case 201 and this case 201 is configured to allow a dialing operation. With this, when a dialing operation is to be carried out, a user's touching on the dial (resin case 201) can be detected. In this way, the inventive proximity sensor 100 can be applied to a rotary switch having a touch sensor.

### [Other Embodiments]

In the foregoing embodiment, it was explained that the electrode section 10 is formed cylindrical. Alternatively, this electrode section 10 can be formed like an angular pillar or an oval shaped.

In the foregoing embodiment, it was explained that the detecting section 30 is mounted on one of the faces of the substrate 20 which one face faces the other side in the axial direction of the tubular body, namely, at the axial end portion where the connecting terminals 11 are not provided. However, the detecting section 30 can be mounted on the one side in the axial direction of the tubular body of the faces of the substrate 20, namely, the face thereof facing the same direction as the side where the connecting terminals 11 are provided as seen from the axial center of the detecting portion 30.

In the foregoing embodiment, it was explained that the connecting terminals 11 are provided to protrude on the radial inner side of the tubular body on the one side in the axial direction. Alternatively, the connecting terminals 11 can be provided to protrude on the radial outer side of the tubular body on the one side in the axial direction.

This disclosure can be used in a proximity sensor configured to detect proximity of an object based on electrostatic capacitance.

## Claims

1. A proximity sensor (100) configured to detect proximity of an object based on an electrostatic capacitance, the proximity sensor comprising:
an electrode section (10) comprised of a tubular body formed by using a metal material and having a connecting terminal (11) on one side in an axial direction of the tubular body;
a substrate (20) having a land (21) formed in correspondence in position to the connecting terminal (11), the connecting terminal (11) being fusedly solder-bonded to the land (21), with the tubular body being disposed vertically; and
a detecting section (30) mounted on the substrate (20) and configured to detect the proximity of the object according to a change that occurs in an electrostatic capacitance at the electrode section (10).

2. The proximity sensor (100) of claim 1, wherein the electrode section (10) is formed cylindrical.

3. The proximity sensor (100) of claim 1 or 2, wherein the detecting section (30) is mounted to one of faces of the substrate (20) which one face is directed toward the other end in the axial direction of the tubular body.

4. The proximity sensor (100) of any one of claims 1-3, wherein the connecting terminal (11) is arranged to protrude on the radial inner side of the tubular body on the one side in the axial direction.
